# EUROPEAN PATENT APPLICATION

(11) **EP 2 045 004 A1**
(43) Date of publication of application: **08.04.2009**
(21) Application number: 08164902.2
(22) Date of filing: 23.09.2008
(51) Int. Cl.: B01J 19/00, C12Q 1/68, C40B 50/14

(54) **Method of manufacturing polymer array by coating photosensitizer**

(30) Priority: 04.10.2007 KR 20070099877
(71) Applicant: Samsung Electronics Co., Ltd., Suwon-si, Gyeonggi-do 442-743 (KR)
(72) Inventor: Yoo, Chang-eun, Seoul (KR); Chi, Sung-min, Gyeonggi-do (KR)
(74) Representative: Grünecker, Kinkeldey, Stockmair & Schwanhäusser Anwaltssozietät

(57) **Abstract**

Provided is a method of manufacturing a polymer array by photolithography in which a molecule containing a photolabile protecting group is reacted with a surface of a substrate, and then a photosensitizer is coated on the surface of the substrate together with a coating material and the resulting substrate is exposed to light to perform a photochemical reaction. Even by using conventional semiconductor equipment and compounds without separately fabricating light exposure equipment or synthesizing a compound, a polymer array may be effectively manufactured by photolithography with lower exposure energy (shorter period of time).

## Description

### PRIORITY STATEMENT

This application claims priority to Korean Patent Application No. 10-2007-0099877, filed on October 4, 2007, in the Korean Intellectual Property Office (KIPO).

### BACKGROUND

### 1. Field

Example embodiments relate to a method of manufacturing a polymer array by coating a photosensitizer, and more particularly, to a method of manufacturing a polymer array by photolithography, by which a molecule containing a photolabile protecting group may be reacted with a surface of a substrate, and then a photosensitizer may be coated on the substrate together with a coating material and the resulting substrate may be exposed to light to perform a photochemical reaction.

### 2. Description of the Related Art

DNA chips have played a critical role in a variety of fields, for example, the diagnosis of hereditary diseases and cancers, mutant searches, detection of pathogenic bacteria, analysis of gene expression and drug development. DNA chips refer to DNA microarrays fabricated by attaching oligonucleotide probes, for example, of which a base sequence may be known, having a minimum of several bases to a maximum of hundreds of bases to a surface of a solid substrate with an area of less than 1 inch² (6.45 cm²), for example, at hundreds to hundred thousands of predetermined or given positions. When a target DNA fragment to be analyzed may be bound to the DNA chip, various hybridizations according to a complementary level between a base sequence of the probe attached to the DNA chip and a base sequence of the target DNA fragment may occur and may be observed and analyzed using an optical method to discover the base sequence of the target DNA.

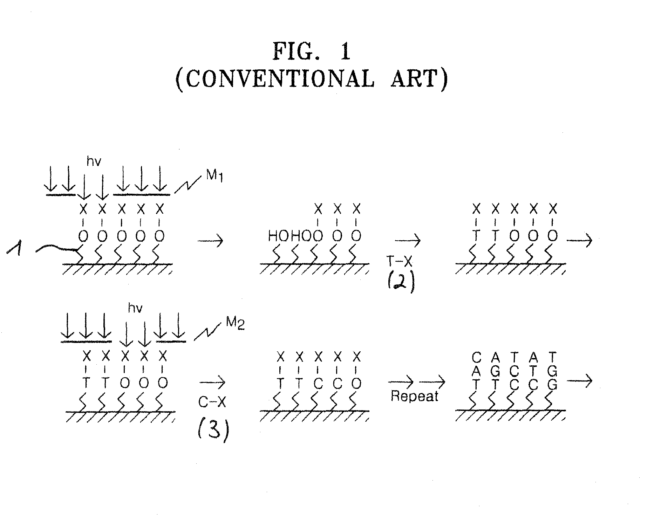

DNA chips may be largely categorized into photolithography chips and spotting chips according to the method of manufacturing the DNA chips. FIG. 1 is a view for describing a conventional method of manufacturing a DNA chip using a photolithography method. That is, a surface of the chip is modified with N-acyl-deoxynucleoside-3'-phosphoramidites, a molecule whose 5'-terminus is protected with a photolabile material, and then, when UV is irradiated to a specific region, the photolabile material in the specific region is cleaved to expose a reactive hydroxyl group, with which a nucleotide protected with a photolabil material at its 5'-terminus is reacted. When these processes are repeatedly performed, a probe having a desired base sequence may be synthesized on the surface of the chip. Referring to FIG. 1, monomer 1, in which 5'-OH may be activated with a photolabile material X and 3'-OH may be activated with phosphoramidite, may be immobilized on a substrate through the 3'-OH group. The substrate may be covered with a mask M1 and the monomer 1 may be selectively exposed to light (hv) to cleave the photolabile material X. Next, the mask M1 may be removed, and the monomer 1 may be reacted with an activated monomer 2, for example, T-X, to bind T-X to the selectively exposed portions of the monomer 1. Then, the resulting substrate may be covered with a mask M2 and the resulting monomer may be selectively exposed to light. The mask M2 may be removed, and the selectively exposed portions of the monomer 1 may be reacted with a monomer 3, for example, C-X, to bind C-X to the monomer 1. By repeatedly performing these processes, probes having various base sequences may be synthesized on the substrate.

To reduce an error rate and a manufacturing time in the process of manufacturing DNA chips by photolithography as described above, a photolabile protecting group has to be removed with a relatively high yield at an appropriate time (energy). According to photochemical reaction theory, to achieve the above-described conditions, a value of ε (extinction coefficient at a specific wavelength) x φ (quantum yield of photochemical reaction) of the photolabile protecting group has to be relatively high. For example, the photolabile protecting group has to absorb light as much as possible or the reactivity of the activated photolabile protecting group has to be improved.

To improve the efficiency of the photoreaction of the photolabile protecting group, examples of using a photosensitizer are known. The related art discloses a chemical material formed by a covalent bond between a photolabile protecting group and a photosensitizer. In addition, the related art discloses a photoreaction method comprising contacting a ph otolabile protecting group and a photosensitizer in a solution state, which requires a different exposer from the conventional one to maintain the solution state for contact, and has its limits in reducing the pitch size of the spot.

### SUMMARY

Example embodiments provide a method of manufacturing a polymer array by coating a photosensitizer. Example embodiments improve the efficiency of a photoreaction even by using conventional semiconductor equipment and synthesized monomers. As a result, a molecule containing a photolabile protecting group can be reacted with a surface of a substrate, and then a photosensitizer can be coated on the substrate together with a coating material and the resulting substrate is exposed to light having a wavelength to perform a photochemical reaction. Therefore, only a relatively low amount of energy is required to remove the photolabile protecting group.

According to example embodiments, a method of manufacturing a polymer array may include reacting a molecule containing a photolabile protecting group with a surface of a substrate to immobilize the molecule onto the substrate, coating the surface of the substrate on which the molecule may be immobilized, with a solution containing a photosensitizer and a coating material, and selectively irradiating electromagnetic radiation to a predetermined or given region on the surface of the substrate with the photosensitizer and coating material coated thereon to cleave the photolabile protecting group from the molecule containing the photolabile protecting group.

### BRIEF DESCRIPTION OF THE DRAWINGS

Example embodiments will be more clearly understood from the following detailed description taken in conjunction with the accompanying drawings. FIGS. 2-3 represent non-limiting, example embodiments as described herein.

FIG. 1 is a view for describing a conventional method of manufacturing a DNA chip using a photolithography method;

FIG. 2 is a graph showing a degree of cleaving a photolabile protecting group according to an exposure energy, represented as fluorescence intensity in the case of coating a photosensitizer or acridone in this case and in the case of not coating a photosensitizer; and

FIG. 3 is a graph showing a degree of cleaving a photolabile protecting group according to exposure energy, represented as fluorescence intensity in the cases of coating a photosensitizer, thioxanthone and acridone, respectively and in the case of not coating a photosensitizer.

It should be noted that these Figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION OF EXAMPLE EMBODIMENTS

Example embodiments will now be described more fully with reference to the accompanying drawings in which example embodiments may be shown. In the drawings, the thicknesses of layers and regions may be exaggerated for clarity. Like reference numerals denote like elements in the drawings and repetitive description thereof will be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers indicate like elements throughout. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

Example embodiments provide a method of manufacturing a polymer array, including reacting a molecule containing a photolabile protecting group with a surface of a substrate to immobilize the molecule onto the substrate, coating the surface of the substrate on which the molecule may be immobilized, with a solution containing a photosensitizer and a coating material, selectively irradiating electromagnetic radiation to a predetermined or given region on the surface of the substrate with the photosensitizer and coating material coated thereon to cleave the photolabile protecting group from the molecule. The molecule may be a monomer. The method may further include removing the photosensitizer and coating material to expose the molecule from which the photolabile protecting group may be cleaved by the irradiation of the electromagnetic radiation, reacting the exposed molecule from which the photolabile protecting group may be cleaved with a further molecule containing a photolabile protecting group to bind the further molecule to the exposed molecule, and repeating the processes of coating the surface of the substrate through reacting the exposed molecule.

Example embodiments include reacting a monomer containing a photolabile protecting group with a surface of a substrate to immobilize the monomer onto the substrate. The monomer may vary depending on whether a polymer to be synthesized may be a nucleic acid, PNA, or peptide. For example, the monomer may be nucleotide, nucleoside, or an amino acid. The photolabile protecting group may be modified to 5'OH or 3'OH of the nucleoside. In addition, the photolabile protecting group may be modified to an N terminal or carboxyl terminal of the amino acid. The modified position depends on whether the nucleic acid may be synthesized in a direction of 5' -> 3' or 3' -> 5'. A portion where the monomer may be immobilized onto the substrate may be different from a portion where the photolabile protecting group may be modified. For example, if the photolabile protecting group may be modified to 5'OH of the nucleoside, the monomer may be immobilized onto the substrate through 3'OH of the nucleoside, or may be immobilized onto the substrate by modifying a material, e.g., phosphoramidite, thereto and through the material. Herein, the surface of the substrate may be activated with a reactive group in order to be reacted with the molecule containing the photolabile protecting group to immobilize the molecule onto the substrate. For example, the surface of the substrate may be activated with an amino group by being coated with a material, e.g., γ-aminopropyltriethoxysilane (GAPTES).

The photolabile protecting group may be 2-(3,4-methylenedioxy-2-nitrophenyl)oxycarbonyl (MeNPOC), 2-(2-nitrophenyl)propyloxycarbonyl (NPPOC), 2-(2-nitrophenyl)ethylsulfonyl (NPES), 2-(2-nitrophenyl)propylsulfonyl (NPPS), 2-(3,4-methylenedioxy-2-nitrophenyl)propyloxycarbonyl (MeNPPOC), 2-(5-phenyl-2-nitrophenyl)-propyloxycarbonyl (PhNPPOC), dimethoxybenzoinyloxycarbonyl (DMBOC), or dimethyltrityl (DMT); however, example embodiments are not limited thereto.

Example embodiments include coating the surface of the substrate on which the monomer may be immobilized, with a solution containing a photosensitizer and a coating material. A photosensitizer refers to a material which absorbs electromagnetic radiation to transfer the electromagnetic radiation to another material (the photolabile protecting group in example embodiments) by triplet-triplet transition. In addition, the "coating material" refers to an adhesive material which may coat the photosensitizer on the substrate.

The photosensitizer may include at least one selected from the group consisting of acridone, 10-methyl-9-acridinone, xanthone, thioxanthone, benzophenone, and 2-acetyl-naphthalene; however, example embodiments are not limited thereto. The coating material may be any material that does not interfere with the energy transfer to the photolabile protecting group from the photosensitizer. For example, if electromagnetic radiation with a wavelength of about 330 to about 380 nm is used, the coating material may be a resin including a copolymer of cyclic olefin and acrylate.

The cyclic olefin may be a compound represented bv Formula 1 below:

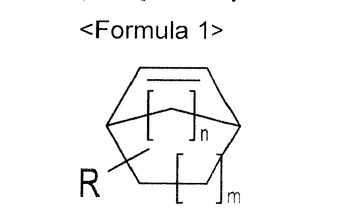

wherein n may be 0 or 1, m may be 0 or 1, and R may be a hydrogen or halogen atom, a C₁₋₂₀ saturated or unsaturated linear aliphatic hydrocarbon, a C₃₋₂₀ cyclic aliphatic hydrocarbon, or a cyclic 5- or 6-membered hetero compound containing nitrogen, oxygen, or sulfur.

In addition, the acrylate may be a compound represented by Formula 2 below:

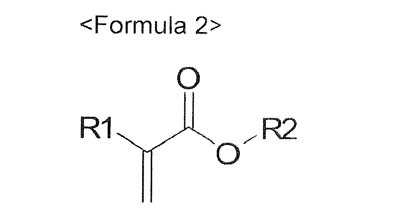

wherein R1 and R2 may be each independently a C₁₋₂₀ saturated or unsaturated linear aliphatic hydrocarbon, or a C₃₋₂₀ cyclic aliphatic hydrocarbon.

The cyclic olefin may be norbornene, and the acrylate may be methylmethacylate; however, example embodiments are not limited thereto. Coating the surface of the substrate with the solution may be performed using various coating methods known in the art, for example, spin coating. The energy absorbed by the photosensitizer may be transferred to the photolabile protecting group, and thus, the photolabile protecting group may be cleaved. Thus, the electromagnetic radiation may be in a wavelength range which maximizes or increases an absorbance of the photosensitizer. During irradiation of the electromagnetic radiation, the photolabile protecting group and photosensitizer may have the maximum absorbance at the same wavelength or in a narrow range of wavelengths, for example, within about 5 nm difference of wavelengths.

Example embodiments include selectively irradiating electromagnetic radiation to a predetermined or given region on the surface of the substrate with the photosensitizer and coating material coated thereon to cleave the photolabile protecting group from the molecule. The selective irradiation may be performed using a patterned mask that may be conventionally used in manufacturing semiconductors.

The wavelength of the electromagnetic radiation may be selected according to the photolabile protecting group and photosensitizer used, however, may be in a UV/VIS wavelength region, for example, a wavelength of about 280 to about 400 nm. For example, if the photolabile protecting group used is 2-(3,4-methylenedioxy-2-nitrophenyl)oxycarbonyl (MeNPOC), 2-(2-nitrophenyl)propyloxycarbonyl (NPPOC), 2-(2-nitrophenyl)ethylsulfonyl (NPES), 2-(2-nitrophenyl)propylsulfonyl (NPPS), 2-(3,4-methylenedioxy-2-nitrophenyl)propyloxycarbonyl (MeNPPOC), 2-(5-phenyl-2-nitrophenyl)-propyloxycarbonyl (PhNPPOC), or dimethoxybenzoinyloxycarbonyl (DMBOC) or dimethyltrityl (DMT) and if the photosensitizer may be acridone, 10-methyl-9-acridinone, xanthone, thioxanthone, benzophenone, or 2-acetyl-naphthalene, the electromagnetic radiation may have a wavelength of about 330 to about 380 nm.

Example embodiments include removing the photosensitizer and coating material to expose the molecule from which the photolabile protecting group may be cleaved by the irradiation of the electromagnetic radiation. Removing the photosensitizer and coating material from the substrate may be performed by washing the substrate with a solution that dissolves the coating material. For example, the washing solution may be at least one of propylene glycol methyl ether acetate (PGMEA) and acetonitrile. By removing the coating material, a molecule from which the photolabile protecting group is cleaved by exposure to light and a further molecule from which the photolabile protecting group is not cleaved may be exposed.

Example embodiments include reacting the exposed molecule from which the photolabile protecting group may be cleaved with a further molecule containing a photolabile protecting group to bind the further molecule to the exposed molecule. The molecule containing a photolabile protecting group may be the same as or different from the molecule immobilized on the substrate. In addition, the molecule containing a photolabile protecting group may be activated to be bound to the exposed molecule. For example, the monomer containing a photolabile protecting group may be a derivative of nucleoside or nucleotide, which may be activated with a desirable leaving group in order to be bound to 5'OH or 3'OH of the exposed monomer.

Example embodiments may include repeating the processes of coating the surface of the substrate through reacting the exposed molecule. Due to the repetitive operations, a polymer in which at least two monomers may be bound to each other, for example, a biopolymer, may be synthesized. The polymer may be DNA, RNA, locked nucleic acid (LNA), peptide nucleic acid (PNA), or peptide.

Example embodiments also provide a method of cleaving a photolabile protecting group from a molecule containing the photolabile protecting group by coating a photosensitizer. Example embodiments include reacting a molecule containing a photolabile protecting group with a surface of a substrate to immobilize the molecule onto the substrate, coating the surface of the substrate on which the molecule may be immobilized, with a solution containing a photosensitizer and a coating material, and selectively irradiating electromagnetic radiation to a predetermined or given region on the surface of the substrate with the photosensitizer and coating material coated thereon to cleave the photolabile protecting group from the molecule containing the photolabile protecting group.

Descriptions of the method of cleaving a photolabile protecting group according to example embodiments may be the same as the method of manufacturing a polymer array according to example embodiments. Herein, the molecule may be a polymer of monomers and also a general compound. The term "monomer" used herein refers to a repeating unit, and thus includes a polymer of a number of monomers as well as a monomer ifself if it can only be a repeating unit. The monomer which is the same molecule or a different molecule can be used in a polymer or a copolymer synthesis.

The electromagnetic radiation may be in a wavelength range which maximizes or increases an absorbance of the photosensitizer. During irradiation of the electromagnetic radiation, the photolabile protecting group and photosensitizer may have the maximum absorbance at the same wavelength or in a narrow range of wavelengths, for example, within about 5 nm difference of wavelengths. The wavelength of the electromagnetic radiation may be selected according to the photolabile protecting group and photosensitizer used; however, may be in a UV/VIS wavelength region.

Hereinafter, example embodiments will be described more specifically with reference to the following examples. The following examples are for illustrative purposes only and are not intended to limit the scope of example embodiments.

### Preparation Example 1: introduction of an amine functional group to a surface of a silicone substrate

About 2.25 g of a surfactant, Fc4430 (Merck, USA) was added to about 28.5 ml of anhydrous ethanol, and the mixture was vortexed for about 2 minutes to be completely dissolved. Then the mixture was added to about 50 ml of ethanol, and subsequently, about 20 ml of γ-aminopropyl triethoxysilane (GAPTES) was added thereto. Next, the resultant was stirred for about 20 minutes and then sonicated for about 10 minutes. About 15 ml of the prepared solution was coated on a surface of a silicone wafer, and the resultant was then spun for about 10 seconds at about 2000 rpm. Then the wafer was baked at about 120°C for about 40 minutes and cooled down at about room temperature for about 10 minutes. Next, the resulting wafer was washed with distilled water for about 10 minutes and sonicated for about 15 minutes, and then washed with distilled water for about 10 minutes again and dried using nitrogen.

### Preparation Example 2: Immobilization of a compound containing a photolabile protecting group on a surface of a substrate

About 45 mg of 2-(3,4-methylenedioxy-2-nitrophenyl)oxycarbonyl-tetraethyleneglycolic acid (MeNPOC-TEG-Acid) was dissolved in about 10 ml of acetonitrile (ACN), and about 46 mg of 2-(1H-7-azabenzotriazole-1-yl)-1,1,3,3-tetramethyluronium hexafluorophosphate methane ammonium (HATU) and about 36 µℓ of triethylamine (TEA) were added thereto. Then, the mixture was vortexed for about 30 seconds. The prepared solution was uniformly coated on the surface of the silicone wafer manufactured in Preparation Example 1, and then the resultant was left for about 30 minutes. The surface of the wafer was washed using about 200ml of ACN, and then spun at about 2000 rpm. While being spun, the surface of the wafer was washed again using about 300 ml of ACN.

### Preparation Example 3: Coating of a photosensitizer

About 5.16% (w/v) of an acryl-based coating material, SB-7003 (Kumho Petrochemical, Korea) (Norbornene, Methylmethacrylate, and Bicyclo[2,2,1]heptylmethacryalte polymerized in a ratio of about 0.26:0.34:0.40) was dissolved in cyclohexanone, and then about 19 mg of acridone or about 25 mg of thioxanthone as a photosensitizer was dissolved in about 10 ml of the mixed solution. The prepared coating solution was uniformly coated on the surface of the wafer on which the compound containing the photolabile protecting group was immobilized, prepared in Preparation Example 2, and then the resultant was spun at about 1500 rpm and baked at about 110°C for about 60 seconds. As a comparative example, a wafer that was not coated with the photosensitizer was separately prepared.

### Preparation Example 4: Exposure, and removement of a coating material/photosensitizer

The wafer coated with the photosensitizer thereon, prepared in Preparation Example 3, was put into a stepper (ASML 200D) equipped with a mask, and then exposed to light having a different energy in the range of about 0 to about 7000 mJ according to wafer image positions.

To remove the coating material and photosensitizer, the resultant was spun at about 1500 rpm. During the spinning of the resultant, about 100 ml of propylene glycol methyl ether acetate (PGMEA) was sprayed on the wafer and about 200 ml of ACN was sprayed thereon. As a comparative example, a wafer that was not coated with the photosensitizer was washed using only ACN after exposure to light.

### Preparation Example 5: Measurement of fluorescence intensity

About 10 µℓ of a solution including about 100 mM of fluorescein phosphoramidite dissolved in ACN, about 15 µℓ of a solution including about 100 mM of DMT(dimethyltrityl)-dT-CEP(cyanoethylphosphoramidite) dissolved in ACN, and about 62.5 µℓ of an Activator 42 solution (proligo company, U.S.A, about 100 mM) were sequentially added to about 25 ml of ACN, and then fully mixed together.
A wafer from which a coating material and photosensitizer were removed was diced into slides each having a size of about 1" x 3". Then, each of the slides was reacted with the mixed solution for about 30 minutes. The slides were washed using ACN for about 10 minutes and using ethanol for about 10 minutes, and then dried with nitrogen. Each of the slides was reacted with about 50% of an ethylenediamine solution (in ethanol) for about 90 minutes, washed using ethanol for about 10 minutes and methanol for about 5 minutes, and then dried with nitrogen. Then, fluorescence intensity of an exposed portion of each of the slides was measured using a scanner (ArrayWork, U.S.A).

### Example 1: Enhancement of light efficiency by coating of a photosensitizer, acridone

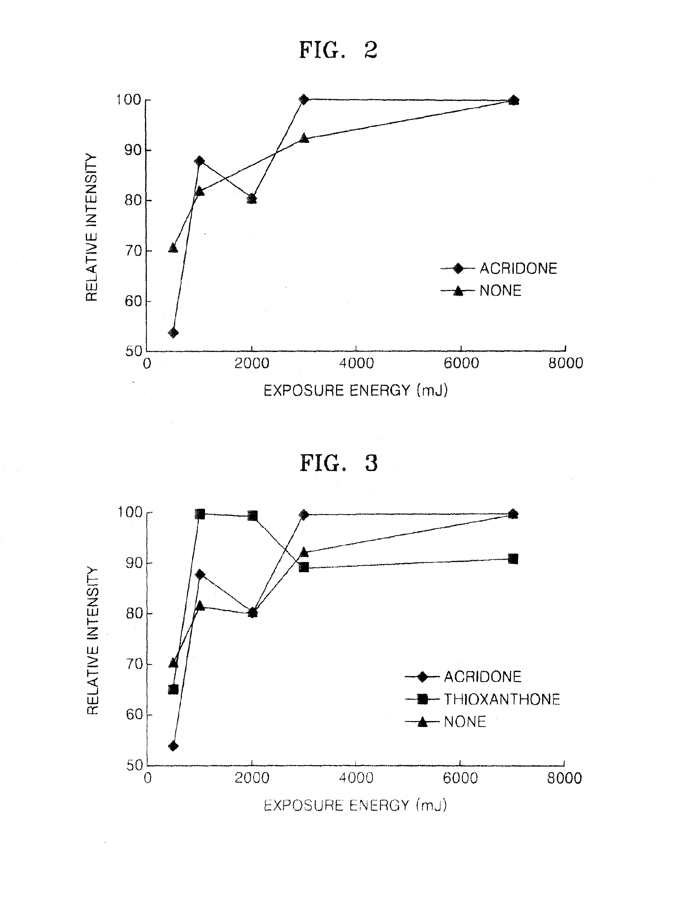

As shown in FIG. 2, a wafer (Example) coated with a photosensitizer, acridone, exhibited a maximum fluorescence intensity of about 3000 mJ, and thus, a photochemical reaction was completed at this point. On the other hand, in the case of a wafer (Comparative Example) that was not coated with the photosensitizer, the fluorescence intensity steadily increased up to about 7000 mJ as exposure energy increased. Thus, when a photochemical reaction is stimulated by coating of a photosensitizer, an energy (or exposure time) needed for completing the reaction may be reduced.

### Example 2: Enhancement of light efficiency by coating of a photosensitizer, thioxanthone

FIG. 3 is a graph showing fluorescence intensity measured by coating different kinds of a photosensitizer. Referring to FIG. 3, when thioxanthone may be used as the photosensitizer, energy needed for reaching the maximum fluorescence intensity may be further reduced to about 1000 to about 2000 mJ, compared with acridone. That is, the energy needed for reaching the maximum fluorescence intensity may be further reduced depending on the type of the photosensitizer.

According to example embodiments, even by using conventional semiconductor equipment and compounds without separately fabricating light exposure equipment or synthesizing a compound, a polymer array may be effectively manufactured by photolithography with lower exposure energy (short period of time).

## Claims

1. A method of manufacturing a polymer array, the method comprising:
a) reacting a molecule containing a photolabile protecting group with a surface of a substrate to immobilize the molecule onto the substrate;
b) coating the surface of the substrate on which the molecule is immobilized, with a solution containing a photosensitizer and a coating material; and
c) selectively irradiating electromagnetic radiation to a region on the surface of the substrate with the photosensitizer and coating material coated thereon to cleave the photolabile protecting group from the molecule containing the photolabile protecting group.

2. The method of claim 1, wherein the electromagnetic radiation irradiated has a wavelength that maximizes or increases absorbance of the photosensitizer.

3. The method of claim 1, wherein the photolabile protecting group and the photosensitizer have the maximum absorbance at the same wavelength when the electromagnetic radiation is irradiated.

4. The method of claim 1, wherein the electromagnetic radiation irradiated has a wavelength in a UV/VIS wavelength region, preferably a wavelength of about 280 to about 400 nm, most preferably a wavelength of about 330 to about 380 nm.

5. The method of claim 1, wherein the photolabile protecting group includes at least one selected from the group consisting of 2-(3,4-methylenedioxy-2-nitrophenyl)oxycarbonyl (MeNPOC), 2-(2-nitrophenyl)propyloxycarbonyl (NPPOC), 2-(2-nitrophenyl)ethylsulfonyl (NPES), 2-(2-nitrophenyl)propylsulfonyl (NPPS), 2-(3,4-methylenedioxy-2-nitrophenyl)propyloxycarbonyl (MeNPPOC), 2-(5-phenyl-2-nitrophenyl)-propyloxycarbonyl (PhNPPOC), dimethoxybenzoinyloxycarbonyl (DMBOC), and dimethyltrityl (DMT).

6. The method of claim 1, wherein the photosensitizer includes at least one selected from the group consisting of acridone, 10-methyl-9-acridinone, xanthone, thioxanthone, benzophenone, and 2-acetyl-naphthalene.

7. The method of claim 1, wherein the coating material is a resin including a copolymer of cyclic olefin and acrylate.

8. The method of claim 7, wherein the cyclic olefin is a compound represented by Formula 1 below: 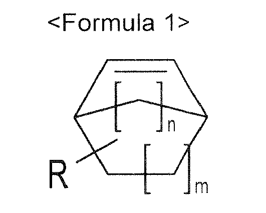 wherein n is 0 or 1, m is 0 or 1, and R is a hydrogen or halogen atom, a C₁₋₂₀ saturated or unsaturated linear aliphatic hydrocarbon, a C₃₋₂₀ cyclic aliphatic hydrocarbon, or a cyclic 5- or 6-membered hetero compound containing nitrogen, oxygen, or sulfur, and
the acrylate is a compound represented by Formula 2 below: 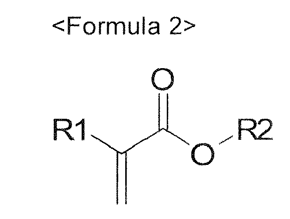 wherein R1 and R2 may be each independently a C₁₋₂₀ saturated or unsaturated linear aliphatic hydrocarbon, or a C₃₋₂₀ cyclic aliphatic hydrocarbon.

9. The method of claim 8, wherein the cyclic olefin is norbornene, and the acrylate is methylmethacylate.

10. The method of claim 1, further comprising:
d) removing the photosensitizer and coating material to expose the molecule from which the photolabile protecting group is cleaved by the irradiation of the electromagnetic radiation;
e) reacting the exposed molecule from which the photolabile protecting group is cleaved with a further molecule containing a photolabile protecting group to bind the further molecule to the exposed molecule; and
f) repeating the steps b) coating the surface of the substrate through e) reacting the exposed molecule.

11. The method of claim 1, wherein the molecule is a monomer or a polymer.

12. The method of claim 11, wherein the monomer is one selected from the group consisting of a nucleotide, a nucleoside, and an amino acid, and wherein the polymer is one selected from the group consisting of DNA, RNA, locked nucleic acid (LNA), peptide nucleic acid (PNA), and peptide.

13. The method of claim 10, wherein removing the photosensitizer and coating material includes washing the substrate with a solution that dissolves the coating material, preferably the washing solution is at least one of propylene glycol methyl ether acetate (PGMEA) and acetonitrile.

14. The method of claim 1, wherein reacting a molecule containing a photolabile protecting group with a surface of a substrate to immobilize the molecule onto the substrate the surface of the substrate includes activating the substrate with a reactive group by coating the substrate with a material.

15. The method of claim 14, wherein the material is γ -aminopropyltriethoxysilane (GAPTES).
